# EUROPEAN PATENT APPLICATION

(11) **EP 0 769 506 A1**
(43) Date of publication of application: **23.04.1997**
(21) Application number: 96115071.1
(22) Date of filing: 19.09.1996
(51) Int. Cl.: C08F 220/36, C08F 290/06, H01L 31/0203

(54) **Plastic lid material for use in semiconductor device packages and production process thereof**

(30) Priority: 03.10.1995 JP 256277/95
(71) Applicant: KUREHA KAGAKU KOGYO KABUSHIKI KAISHA, Chuo-ku Tokyo 103 (JP)
(72) Inventor: Ogihara, Takeo, Nishiki-machi, Iwaki-shi, Fukushima (JP); Katono, Hiroki, Nishiki-machi, Iwaki-shi, Fukushima (JP); Shouji, Masuhiro, Nakoso-machi, Iwaki-shi, Fukushima (JP); Sakagami, Teruo, Nishiki-machi, Iwaki-shi, Fukushima (JP)
(74) Representative: Grünecker, Kinkeldey, Stockmair & Schwanhäusser Anwaltssozietät

(57) **Abstract**

Disclosed herein are a plastic lid material for use in semiconductor device packages, which is low in specific gravity, excellent in moldability and cutting workability, and moreover superb in transparency, bond strength, heat resistance, dimensional stability and solvent resistance, and a production process thereof.

The plastic lid material of the invention is composed of a crosslinked acrylic copolymer obtained by radical-polymerizing a monomer mixture which is composed of 100 parts by mass of a (meth)acrylic ester monomer component composed of a polyfunctional (meth)acrylic ester and a monofunctional (meth)acrylic ester, and 0-50 parts by mass of another monomer component copolymerizable with the (meth)acrylic ester monomer component, wherein the proportion of the polyfunctional (meth)acrylic ester is 10-90 mass% of the monomer mixture. The monomer mixture preferably contains a (meth)acrylic ester having at least one urethane linkage in a proportion of 20-80 mass%.

## Description

### BACKGROUND OF THE INVENTION

### Field of the Invention

The present invention relates to a plastic lid material for use in semiconductor device packages, which is composed of a crosslinked acrylic copolymer.

Here, the lid material for use in semiconductor device packages serves to hermetically seal optical semiconductor devices such as IC and solid-state image pickup devices, thereby protecting the optical semiconductor devices from malfunction or deterioration caused by dust, harmful gas or the like.

### Related Background Art

A glass material has heretofore been used as a lid material for use in semiconductor device packages.

However, the glass material making up the lid material is high in specific gravity and shock-brittle. Besides, the production of the glass lid material may involve breakage upon handling of the glass material or cutting work, so that a high yield cannot be attained. In addition, the cutting work tends to cause chipping, so that post machining is required, and these forms the main cause of increase in production cost.

Some glass materials emit radiation such as α-rays to cause an element memory to malfunction. In order to avoid such a problem, a special glass material must be used.

There is thus a strong demand for development of a plastic lid material which is low in specific gravity, high in strength, easy to mold and cutting, and excellent in dimensional stability and durability.

### SUMMARY OF THE INVENTION

The present invention has been completed in view of the foregoing circumstances and has as its object the provision of a plastic lid material for use in semiconductor device packages, which is low in specific gravity, excellent in moldability and cutting workability, and moreover superb in transparency, bond strength (for example, bond strength to epoxy resin composites), heat resistance, dimensional stability and solvent resistance.

Another object of the present invention is to provide a process for advantageously producing the plastic lid material for use in semiconductor device packages.

According to the present invention, there is thus provided a plastic lid material for use in semiconductor device packages, comprising a crosslinked acrylic copolymer obtained by radical-polymerizing a monomer mixture which is composed of 100 parts by mass of a (meth)acrylic ester monomer component composed of a polyfunctional (meth)acrylic ester and a monofunctional (meth)acrylic ester, and 0-50 parts by mass of another monomer component copolymerizable with the (meth)acrylic ester monomer component, wherein the proportion of the polyfunctional (meth)acrylic ester is 10-90 mass%, preferably 40-90 mass% of the monomer mixture.

In the lid material according to the present invention, the monomer mixture may preferably contain a (meth)acrylic ester having at least one urethane linkage obtained by a urethanation reaction of an isocyanate and a hydroxyl group-containing (meth)acrylic ester in a proportion of 20-80 mass%.

In the lid material according to the present invention, a diffraction grating having an optical low-pass filtering function may be formed in its surface. Alternatively, a diffraction grating layer may be provided on its surface.

According to the present invention, there is also provided a process for producing a plastic lid material for use in semiconductor device packages, which comprises the steps of arranging a pair of molding plates each having an optical plane on a surface thereof with a space between them so as to oppose the optical planes to each other, thereby defining a cavity between the pair of molding plates, and copolymerizing a monomer mixture, which is composed of 100 parts by mass of a (meth)acrylic ester monomer component composed of a polyfunctional (meth)acrylic ester and a monofunctional (meth)acrylic ester, and 0-50 parts by mass of another monomer component copolymerizable with the (meth)acrylic ester monomer component, wherein the proportion of the polyfunctional (meth)acrylic ester is 10-90 mass%, preferably 40-90 mass% of the monomer mixture, in the cavity, thereby forming a molded product of a crosslinked acrylic copolymer.

In the production process of the lid material according to the present invention, the monomer mixture to be copolymerized may preferably contain a (meth)acrylic ester having at least one urethane linkage obtained by a urethanation reaction of an isocyanate and a hydroxyl group-containing (meth)acrylic ester in a proportion of 20-80 mass%.

The production process of the lid material according to the present invention may comprise a step of forming a negative pattern of a diffraction grating having an optical low-pass filtering function on a surface of at least one of the pair of molding plates and copolymerizing the monomer mixture in the cavity defined by the pair of molding plates, thereby forming a molded product having the diffraction grating on its surface.

The production process of the lid material according to the present invention may comprise a step of providing a diffraction grating layer on a surface of the molded product of the crosslinked acrylic copolymer.

The lid materials according to the present invention are low in specific gravity, excellent in moldability and cutting workability, and moreover superb in transparency, bond strength, heat resistance, dimensional stability and solvent resistance.

The crosslinked acrylic copolymer obtained by using the monomer mixture containing the (meth)acrylic ester having at least one urethane linkage in a specified proportion has sufficiently high strength for a lid material for use in semiconductor device packages.

According to the production process of the present invention, the molded product of the crosslinked acrylic copolymer having an optical plane can be directly obtained by the copolymerization of the monomer mixture, so that a surface polishing step becomes unnecessary. As a result, the plastic lid materials for use in semiconductor device packages can be produced easily and efficiently.

### DETAILED DESCRIPTION OF THE INVENTION AND PREFERRED EMBODIMENTS

The present invention will hereinafter be described in detail.

The plastic lid material for use in semiconductor device packages according to the present invention is composed of a crosslinked acrylic copolymer. Such a crosslinked acrylic copolymer is obtained by radical-polymerizing a monomer mixture comprising, as an essential monomer component, a (meth)acrylic ester monomer component composed of a polyfunctional (meth)acrylic ester and a monofunctional (meth)acrylic ester.

The term "(meth)acrylic acid" as used herein means at least one of "acrylic acid" and "methacrylic acid", and the term "(meth)acrylic ester" means at least one of "an acrylic ester" and "a methacrylic ester".

In the monomer mixture used for obtaining the crosslinked acrylic copolymer, the proportion of the polyfunctional (meth)acrylic ester is generally 10-90 mass%, preferably 40-90 mass%, more preferably 60-90 mass%. If this proportion is lower than 10 mass%, the resulting cross linked copolymer becomes low in degree of crosslinking. A lid material composed of such a crosslinked copolymer is insufficient in dimensional stability and heat resistance. On the other hand, the proportion exceeding 90 mass% may result in a crosslinked copolymer too high in degree of crosslinking and brittle.

As the (meth)acrylic ester monomers in the present invention, there may preferably be used those containing a monofunctional (meth)acrylic ester having one or more urethane linkages and/or a polyfunctional (meth)acrylic ester having one or more urethane linkages (hereinafter may be referred to as "urethane linkage-containing (meth)acrylic ester"). The use of the monomer mixture containing such a urethane linkage-containing (meth)acrylic ester ensures the provision of a crosslinked acrylic copolymer having sufficiently high strength for a lid material intended.

The urethane linkage-containing (meth)acrylic ester is obtained by the urethanation reaction of an isocyanate and a (meth)acrylic ester having at least one hydroxyl group (hereinafter referred to as "hydroxyl group-containing (meth)acrylic ester").

As the isocyanate used for obtaining the urethane linkage-containing (meth ) acrylic ester, any of monoisocyanates having one isocyanate group in their individual molecules and polyisocyanates having at least two isocyanate groups in their individual molecules may be used.

Specific examples of the monoisocyanate having one isocyanate group in its molecule include methyl isocyanate, ethyl isocyanate, propyl isocyanate, butyl isocyanate, octadecyl isocyanate, phenyl isocyanate, m-chlorophenyl isocyanate and methacryloyloxyethyl isocyanate.

Specific examples of the polyisocyanate having at least two isocyanate groups in its molecule include hexamethylene diisocyanate, octamethylene diisocyanate, nonamethylene diisocyanate, isophorone diisocyanate, 2,2,4-trimethylhexamethylene diisocyanate, dicyclohexylmethane diisocyanate, lysine diisocyanate methyl ester, tetramethylene diisocyanate, xylylene diisocyanate, bis(isocyanatomethyl)cyclohexane, tolylene diisocyanate, 4,4'-diphenylmethane diisocyanate, tolidine diisocyanate, naphthalene diisocyanate, 3,3'-dimethyl-4,4'-bisphenylene diisocyanate, a biuret reaction product of hexamethylene diisocyanate, trifunctional and/or tetrafunctional isocyanates derived from trimethylol-propane and isophorone diisocyanate, 2-isocyanatoethyl 2,6-diisocyanatohexanoate, 1,6,11-undecane triisocyanate and 4,4',4''-isocyanatotriphenylmethane.

These compounds may be used either singly or in any combination thereof.

As specific examples of the hydroxyl group-containing (meth)acrylic ester used for obtaining the urethane linkage-containing (meth)acrylic ester, may be mentioned 2-hydroxyethyl acrylate, 2-hydroxypropyl acrylate, 2-hydroxypropyl methacrylate, 2-hydroxybutyl acrylate, 3-hydroxypropyl methacrylate, 4-hydroxybutyl methacrylate, 2-hydroxy-3-chloropropyl acrylate, 2-hydroxy-3-chloropropyl methacrylate, 2-hydroxy-3-phenoxypropyl acrylate and 3-acryloyloxyglycerol monomethacrylate.

These compounds may be used either singly or in any combination thereof.

The proportion of the urethane linkage-containing (meth)acrylic ester in the monomer mixture is generally 20-80 mass%, preferably 30-70 mass%, more preferably 35-60 mass%.

If this proportion is lower than 20 mass%, the resulting crosslinked acrylic copolymer may not become a polymer having sufficiently high strength for a lid material intended. On the other hand, the proportion exceeding 80 mass% may result in a crosslinked acrylic copolymer too low in heat resistance occasionally.

Specific examples of polyfunctional (meth)acrylic esters having no urethane linkage, among the (meth)acrylic ester monomers usable in the present invention, include ethylene glycol diacrylate, ethylene glycol dimethacrylate, polyethylene glycol diacrylate, polyethylene glycol dimethacrylate, 1,4-butanediol diacrylate, 1,4-butanediol dimethacrylate, trimethylolpropane triacrylate, diethylene glycol dimethacrylate, 2,2-bis(4-methacryloxyethoxyphenyl)propane, pentaerythritol trimethacrylate and pentaerythritol tetramethacrylate.

Specific examples of monofunctional (meth)acrylic esters having no urethane linkage among the (meth)acrylic ester monomers usable in the present invention, include lower alkyl (meth)acrylates the alkyl group of which has 1-8 carbon atoms, such as methyl acrylate, methyl methacrylate, ethyl acrylate, ethyl methacrylate, n-propyl acrylate, n-propyl methacrylate, t-butyl acrylate and t-butyl methacrylate; and modified alkyl (meth)acrylates obtained by substituting a glycidyl group or a hydroxyalkyl group for the alkyl group in an alkyl (meth)acrylate, such as glycidyl acrylate, glycidyl methacrylate and 2-hydroxybutyl methacrylate.

In the present invention, a monomer copolymerizable with any one or more of the monomers in the (meth)acrylic ester monomer component (hereinafter referred to as "copolymerizable monomer") may be included in the monomer mixture used for obtaining the crosslinked acrylic copolymer. The inclusion of the copolymerizable monomer in the monomer mixture permits, for example, lowering the viscosity of the monomer mixture itself, regulating polymerization rate, adjusting performance characteristics of the resulting crosslinked acrylic copolymer, such as refractive index, and so on.

As specific examples of such a copolymerizable monomer, may be mentioned carboxylic acids having an unsaturated bond, such as acrylic acid and methacrylic acid, aromatic vinyl compounds such as styrene, α-methylstyrene, halogenated styrene, methoxystyrene and divinylbenzene. These compounds may be used either singly or in any combination thereof.

The proportion of the copolymerizable monomer to be used is generally 0-50 parts by mass, preferably 0-30 parts by mass per 100 parts by mass of the (meth)acrylic ester monomer component.

The proportion of the copolymerizable monomer exceeding 50 parts by mass results in lowering the yield of the copolymer, and the resultant copolymer has lowered cutting workability and is brittle.

The crosslinked acrylic copolymer making up the lid material according to the present invention is obtained by radical-polymerizing the monomer mixture as above-mentioned.

As a radical polymerization process for obtaining the crosslinked acrylic copolymer, there may be used any known polymerization process making use of a usual polymerization initiator, such as a cast polymerization process, suspension polymerization process, emulsion polymerization process or solution polymerization process. Since the resulting crosslinked acrylic copolymer is difficult to form by melt-molding, it is preferable to use the cast polymerization process, by which a product having an intended form can be directly given, among the above-mentioned polymerization processes.

When the crosslinked acrylic copolymer is obtained by the cast polymerization process, it is preferable to use, as a mold material, a molding plate composed of glass or the like having an optical plane on a surface thereof.

The term "optical plane" as used herein means a plane surface finished so as to have surface roughness of 5 µm or smaller, and having flatness of 0.05 µm or smaller as the whole plane, and specifically means a plane having only a few Newton's rings when measured by means of a laser interferometer or an optical flat mastergage.

The cast polymerization process used for obtaining the crosslinked acrylic copolymer will be described specifically. A pair of the above-described molding plates are arranged with a space or a gap between them so as to oppose their optical planes to each other. A sealing and fixing member composed of a pressure sensitive adhesive tape is provided in common along the outer peripheral surfaces of these molding plates to fix them and at the same time, cover the outer periphery of the space, thereby defining a cavity for the cast polymerization surrounded by the optical planes and the sealing and fixing member. A monomer composition composed of the monomer mixture and a radical polymerization initiator is then charged into the cavity and heated or exposed to light, thereby copolymerizing the monomer mixture. By this process, a sheet- or plate-like molded product composed of the crosslinked acrylic copolymer is obtained.

According to the above-described process, the molded product having an optical plane on its surface and composed of the crosslinked acrylic copolymer can be directly obtained by the copolymerization of the monomer mixture. The molded product may be subjected to cutting work as needed, thereby obtaining a lid material intended. Accordingly, a surface polishing step, which is an essential step for forming an optical plane in the production of the conventional glass lid material, becomes unnecessary and may be omitted, so that a lid material can be produced with ease.

The thus-obtained lid material composed of the crosslinked acrylic copolymer is in the form of a sheet or plate having a specific gravity of 1.0-1.5 and a thickness of 0.1-3 mm and has the following performance characteristics. Namely, the transmittance of visible rays is not lower than 80%, the heat distortion point (Vicat softening temperature) is not lower than 70°C, and the water absorption is not higher than 3%. In addition, the lid material does substantially not contain any substance which emits radiation such as α-rays and is hence extremely suitable for a lid material for use in semiconductor device packages because of no undesirable influence on the elements.

In the lid material according to the present invention, a diffraction grating having an optical low-pass filtering function may be provided in its surface. Alternatively, a diffraction grating layer may be provided on its surface. The lid material having such a diffraction grating on its surface has an optical low-pass filtering function of limiting a high spatial frequency component of light from a subject to remove a color component different from that of the subject, which is attendant on the generation of a false signal and is hence suitable for a lid material for use in a semiconductor device package of a solid-state image pickup device of which such a function is required.

The diffraction grating having an optical low-pass filtering function may be provided either by directly forming it in a surface of the molded product composed of the crosslinked acrylic copolymer or by laminating a diffraction grating layer on a surface of the molded product.

As examples of the process for directly forming the diffraction grating in the surface of the molded product, may be mentioned a process in which in the cast polymerization process, a negative pattern of the diffraction grating is formed on a surface of at least one of the pair of molding plates, by which a cavity is defined, and the monomer mixture is copolymerized in the cavity defined by the pair of molding plates, thereby directly obtaining a molded product on the surface of which the diffraction grating has been formed, and a process in which a stamper, in the surface of which a negative pattern of the diffraction grating has been formed, is brought into contact under heat with a surface of the molded product of the crosslinked acrylic copolymer, thereby forming the diffraction grating.

As examples of the process for providing the diffraction grating layer on the surface of the molded product, may be mentioned various processes such as a process in which for example, silicon dioxide is applied by vacuum deposition or evaporation onto a surface of the molded product of the crosslinked acrylic copolymer, thereby forming the diffraction grating layer, a process in which a photosensitive resin is evenly coated on a surface of the molded product and subjected to exposure and development using a patterned mask having an image corresponding to the diffraction grating, thereby forming a resin layer having a diffraction grating pattern on the surface of the molded product, and a process in which a filmy diffraction grating member (hereinafter referred to as "diffraction grating film") formed from an optical resin in advance is laminated on a surface of the molded product.

When an adhesive or pressure sensitive adhesive is used to laminate the diffraction grating film on the surface of the molded product, there may suitably be used adhesives which are thermosetting or photosetting compositions and have excellent transparency, for example, epoxy, urethane and acrylic adhesives, and pressure sensitive adhesives excellent in transparency and weather resistance, for example, acrylic pressure sensitive adhesives.

A hard coat layer and/or an antireflection layer may be provided by post-processing on the surface of the plastic lid materials for use in semiconductor device packages according to the present invention.

The present invention will hereinafter be described more specifically by the following examples. However, the present invention is not limited to and by these examples. Incidentally, all designations of "part" or "parts" as will be used in the following examples mean part or parts by mass.

### Example 1:

### [Preparation of monomer composition]

A monomer composition was prepared by mixing 45 parts of a reaction product of a cyclic trimer (1 mol) of hexamethylene diisocyanate and 2-hydroxy-3-phenoxypropyl acrylate (3 mol) as a polyfunctional (meth)acrylic ester having urethane linkages, 5 parts of pentaerythritol tetraacrylate as a polyfunctional (meth)acrylic ester having no urethane linkage, 30 parts of t-butyl methacrylate as a monofunctional (meth)acrylic ester having no urethane linkage, 20 parts of α-methylstyrene as a copolymerizable monomer, and 1.5 parts of t-butyl peroxypivalate as a polymerization initiator.

### [Cast polymerization]

A pair of glass molding plates each having an optical plane on a surface thereof were arranged with a space of 1 mm so as to oppose their optical planes to each other, thereby defining a cavity. The above-prepared monomer composition was cast into the cavity and successively heated at varied temperatures as 50°C for 10 hours, 70°C for 4 hours and 100°C for 3 hours to conduct the cast polymerization of the monomer composition, thereby obtaining a transparent, disk-like molded product composed of a crosslinked acrylic copolymer and having a diameter of 76 mm and a thickness of 1 mm.

This molded product was cut into 9 mm by 9 mm in size, thereby obtaining a plastic lid material for use in semiconductor device packages according to the present invention.

The specific gravity, refractive index (n_{D}) and light transmittance (according to JIS K 6714) of the lid material thus obtained were measured at 23 °C , and evaluation was conducted as to the following items.

### [Heat resistance]

Evaluated by measuring a Vicat softening temperature in accordance with JIS K 7206, Method B.

### [Molding strain]

The degree of strain was determined by means of a strain detector PE-P (manufactured by Mizojiri Kogaku Kogyo-sho) to evaluate the molded product as to the molding strain and rank it as "Small (S)" where the number of interference fringes was few, or "Great (G)" where the number of interference fringes was many.

### [Cutting workability]

The molded product was further cut by a diamond blade using a dicing saw 2H6T (manufactured by Disco Co.) to observe its cut edge, and evaluated the molded product as to the cutting workability and ranked it as "A" where no chipping occurred, or "B" where chipping occurred.

### [Bond strength]

After the lid material was bonded to a packaging material composed of epoxy resin composite with a thermosetting adhesive, and they were kept for 4 hours at 130°C in a fixed state by a jig, the lid material was observed to evaluate it as to the bond strength and rank it as "AA" where neither cracking nor deformation occurred at all, "A" where deformation somewhat occurred, or "B" where a bonding failure, cracking or deformation occurred.

### [Solvent resistance]

After samples formed from the molded product were separately immersed for 24 hours at 23°C in individual solvents of ethyl alcohol, acetone and toluene, they were observed to evaluate them as to the solvent resistance and rank each of them as "A" where it was not damaged at all, or "B" where it was swollen with or dissolved in the solvent, or cracked.

The results thereof are shown in Table 1.

### Example 2:

A lid material for use in semiconductor device packages according to the present invention was produced and then evaluated in the same manner as in Example 1 except that a monomer composition was prepared by mixing 60 parts of triethylene glycol dimethacrylate as a polyfunctional (meth)acrylic ester having no urethane linkage, 10 parts of methyl methacrylate and 5 parts of glycidyl methacrylate as monofunctional (meth)acrylic esters having no urethane linkage, 5 parts of styrene and 20 parts of α-methylstyrene as copolymerizable monomers, and 1 part of t-butyl peroxypivalate as a polymerization initiator. The results of the evaluations are shown in Table 1.

### Example 3:

A monomer composition was prepared by mixing 35 parts of a reaction product of a cyclic trimer (1 mol) of hexamethylene diisocyanate and 2-hydroxy-3-phenoxypropyl acrylate (3 mol) as a polyfunctional (meth)acrylic ester having urethane linkages, 55 parts of triethylene glycol dimethacrylate as a polyfunctional (meth)acrylic ester having no urethane linkage, 10 parts of glycidyl methacrylate as a monofunctional (meth)acrylic ester having no urethane linkage, and 1 part of t-butyl peroxypivalate as a polymerization initiator.

A lid material for use in semiconductor device packages according to the present invention was produced and then evaluated in the same manner as in Example 1 except that the above-prepared monomer composition was used, and cast polymerization was conducted by successively heating at varied temperatures, namely, maintaining the monomer composition at 40°C for 4 hours, raising the temperature from 40°C to 50°C over 6 hours, and then heating it at 70°C for 4 hours and at 100°C for 3 hours. The results of the evaluations are shown in Table 1.

### Example 4:

A lid material for use in semiconductor device packages according to the present invention was produced and then evaluated in the same manner as in Example 1 except that a monomer composition was prepared by mixing 60 parts of a reaction product of dicyclohexylmethane diisocyanate (1 mol), 2-hydroxy-3-phenoxypropyl acrylate (1 mol) and glycerol dimethacrylate (1 mol) as a polyfunctional (meth)acrylic ester having urethane linkages, 10 parts of glycidyl methacrylate as a monofunctional (meth)acrylic ester having no urethane linkage, 20 parts of styrene and 10 parts of α-methylstyrene as copolymerizable monomers, and 1 part of t-butyl peroxypivalate as a polymerization initiator. The results of the evaluations are shown in Table 1.

### Example 5:

A lid material for use in semiconductor device packages according to the present invention was produced and then evaluated in the same manner as in Example 1 except that a monomer composition was prepared by mixing 10 parts of pentaerythritol tetraacrylate as a polyfunctional (meth)acrylic ester having no urethane linkage, 50 parts of a reaction product of a methacryloyloxyethyl isocyanate (1 mol) and t-butyl alcohol (1 mol) as a monofunctional (meth)acrylic ester having a urethane linkage, 30 parts of t-butyl methacrylate as a monofunctional (meth)acrylic ester having no urethane linkage, 10 parts of α-methylstyrene as a copolymerizable monomer, and 1.5 parts of t-butyl peroxypivalate as a polymerization initiator. The results of the evaluations are shown in Table 1.

### Comparative Example 1:

A glass lid material was produced, and evaluated as to the above-described items other than the heat resistance in the same manner as in Example 1. The results of the evaluations are shown in Table 1.

### Comparative Example 2:

A lid material composed of a polycarbonate resin was produced, and evaluated as to the above-described items other than the heat resistance in the same manner as in Example 1. The results of the evaluations are shown in Table 1.

### Comparative Example 3:

A lid material composed of a polymethyl methacrylate resin was produced, and evaluated in the same manner as in Example 1. The results of the evaluations are shown in Table 1.

### Comparative Example 4:

A polymer was obtained in the same manner as in Example 1 except that a monomer composition was prepared by mixing 100 parts of diethylene glycol dimethacrylate, a polyfunctional (meth)acrylic ester, and 1 part of t-butyl peroxypivalate, a polymerization initiator. A lid material was produced from this polymer and then evaluated in the same manner as in Example 1. The results of the evaluations are shown in Table 1.

### Comparative Example 5:

A copolymer was obtained in the same manner as in Example 1 except that a monomer composition was prepared by mixing 30 parts of triethylene glycol dimethacrylate as a polyfunctional (meth)acrylic ester, 10 parts of methyl methacrylate as a monofunctional (meth)acrylic ester, 60 parts of styrene as a copolymerizable monomer and 1 part of t-butyl peroxypivalate as a polymerization initiator. The monomer composition contains a copolymerizable monomer in an excess proportion. A lid material was produced from this copolymer and then evaluated in the same manner as in Example 1. The results of the evaluations are shown in Table 1.

**Table 1**

| | | Example | | | | | Comparative Example | | | | |
|---|---|---|---|---|---|---|---|---|---|---|---|
| | | 1 | 2 | 3 | 4 | 5 | 1 | 2 | 3 | 4 | 5 |
| Specific gravity 23°C) | | 1.13 | 1.23 | 1.18 | 1.14 | 1.13 | 2.44 | 1.20 | 1.19 | 1.19 | 1.12 |
| Refractive index (n_{D}) | | 1.53 | 1.51 | 1.51 | 1.54 | 1.53 | 1.506 | 1.585 | 1.490 | 1.51 | 1.55 |
| Light transmittance (%) | | 92 | 92 | 92 | 92 | 92 | 90 | 88 | 92 | 90 | 90 |
| Vicat softening temperature (°C) | | 110 | > 150 | > 150 | > 150 | 112 | - | - | 104 | 150 | 110 |
| Molding strain | | S | S | S | S | S | S | G | G | S | S |
| Cutting workability | | A | A | A | A | A | B | B | B | A | B |
| Bond strength | | AA | A | AA | AA | AA | AA | B | B | B | B |
| Solvent resistance | Ethyl alcohol | A | A | A | A | A | A | A | A | A | A |
| | Acetone | A | A | A | A | A | A | B | B | A | B |
| | Toluene | A | A | A | A | A | A | B | B | B | B |

As apparent from Table 1, it was confirmed that the lid materials according to the present invention of Examples 1-5 have better transparency, lower specific gravity and excellent cutting workability as compared with the glass lid material (Comparative Example 1). It was also confirmed that they are smaller in molding strain, excellent in cutting workability, and moreover superb in heat resistance, solvent resistance and bond strength as compared with the lid materials made of the polycarbonate (Comparative Example 2) and the polymethyl methacrylate (Comparative Example 3).

In particular, the lid materials according to the present invention of Examples 1 and 3-5 had extremely high bond strength because they were produced with a monomer mixture containing a urethane linkage-containing (meth)acrylic ester in a proportion of 35-60 mass%.

### Example 6:

A lid material according to the present invention, in the surface of which a diffraction grating was directly formed, was produced in the same manner as in Example 4 except that in the cast polymerization of the monomer composition, a glass molding plate, on the cavity-defining inner surface of which a negative pattern of a diffraction grating comprising parallel-arranged ditches each having a trapezoidal sectional shape with a depth of 0.5 µm and a pitch of 0.1 mm had been formed with a vacuum deposition film of silicon dioxide (SiO₂), was used as one of the pair of glass molding plates.

A semiconductor device sealed with this lid material was incorporated into a solid-state image pickup device to conduct a practical test. As a result, it was confirmed that the lid material has a good optical low-pass filtering function, as well.

### Example 7:

A transparent, disk-like molded product composed of a crosslinked acrylic copolymer and having a diameter of 76 mm and a thickness of 1 mm was obtained in the same manner as in Example 4. After cutting the molded product into square pieces of 9 mm by 9 mm in size, a diffraction grating layer having a linear diffraction grating pattern comprising parallel-arranged ditches each having a trapezoidal sectional shape with a depth of 0.5 µm and a pitch of 0.05 mm was formed on the surface of each of the cut piece by a vacuum deposition of silicon dioxide (SiO₂).

A semiconductor device sealed with the lid material thus obtained was incorporated into a solid-state image pickup device to conduct a practical test. As a result, it was confirmed that the lid material has a good optical low-pass filtering function, as well.

## Claims

1. A plastic lid material for use in semiconductor device packages, comprising a crosslinked acrylic copolymer obtained by radical-polymerizing a monomer mixture which is composed of 100 parts by mass of a (meth)acrylic ester monomer component composed of a polyfunctional (meth)acrylic ester and a monofunctional (meth)acrylic ester, and 0-50 parts by mass of another monomer component copolymerizable with the (meth)acrylic ester monomer component, wherein the proportion of the polyfunctional (meth)acrylic ester is 10-90 mass% of the monomer mixture.

2. The plastic lid material according to Claim 1, wherein the proportion of the polyfunctional (meth)acrylic ester is 40-90 mass% of the monomer mixture.

3. The plastic lid material according to Claim 1, wherein the monomer mixture to be radical-polymerized contains a (meth)acrylic ester having at least one urethane linkage obtained by a urethanation reaction of an isocyanate and a hydroxyl group-containing (meth)acrylic ester in a proportion of 20-80 mass%.

4. The plastic lid material according to Claim 1, wherein the monomer mixture to be radical-polymerized contains a (meth)acrylic ester having at least one urethane linkage obtained by a urethanation reaction of an isocyanate and a hydroxyl group-containing (meth)acrylic ester in a proportion of 30-70 mass%.

5. The plastic lid material according to Claim 1, wherein a diffraction grating having an optical low-pass filtering function is formed in the surface of the lid material.

6. The plastic lid material according to Claim 1, wherein a diffraction grating layer having an optical low-pass filtering function is provided on the surface of the lid material.

7. A process for producing a plastic lid material for use in semiconductor device packages, which comprises the steps of:
arranging a pair of molding plates each having an optical plane on a surface thereof with a space between them so as to oppose the optical planes to each other, thereby defining a cavity between the pair of molding plates; and
copolymerizing a monomer mixture, which is composed of 100 parts by mass of a (meth)acrylic ester monomer component composed of a polyfunctional (meth)acrylic ester and a monofunctional (meth)acrylic ester, and 0-50 parts by mass of another monomer component copolymerizable with the (meth)acrylic ester monomer component, wherein the proportion of the polyfunctional (meth)acrylic ester is 10-90 mass% of the monomer mixture, in the cavity, thereby forming a molded product of a crosslinked acrylic copolymer.

8. The process according to Claim 7, wherein the proportion of the polyfunctional (meth)acrylic ester is 40-90 mass% of the monomer mixture.

9. The process according to Claim 7, wherein the monomer mixture to be copolymerized contains a (meth)acrylic ester having at least one urethane linkage in a proportion of 20-80 mass%.

10. The process according to Claim 7, wherein the monomer mixture to be copolymerized contains a (meth)acrylic ester having at least one urethane linkage in a proportion of 30-70 mass%.

11. The process according to Claim 7, which comprises a step of forming a negative pattern of a diffraction grating having an optical low-pass filtering function on a surface of at least one of the pair of molding plates and copolymerizing the monomer mixture in the cavity defined by the pair of molding plates, thereby forming a molded product having the diffraction grating on its surface.

12. The process according to Claim 7, which comprises a step of providing a diffraction grating layer on a surface of the molded product of the crosslinked acrylic copolymer.
